(19) Europäisches Patentamt
European Patent Office
Office européen des brevets

(11) Veröffentlichungsnummer : **0 108 283**
**B1**

(12) **EUROPÄISCHE PATENTSCHRIFT**

(45) Veröffentlichungstag der Patentschrift :
01.02.89

(51) Int. Cl.⁴ : **H 03 K 17/10, H 03 K 17/08**

(21) Anmeldenummer : 83110221.5

(22) Anmeldetag : 13.10.83

(54) Elektronischer Schalter. -

(30) Priorität : 04.11.82 DE 3240778

(43) Veröffentlichungstag der Anmeldung :
16.05.84 Patentblatt 84/20

(45) Bekanntmachung des Hinweises auf die Patenterteilung : 01.02.89 Patentblatt 89/05

(84) Benannte Vertragsstaaten :
AT CH DE FR GB IT LI NL SE

(56) Entgegenhaltungen :
DE--A-- 1 804 302
US--A-- 4 274 014
IEEE TRANSACTIONS ON INDUSTRY APPLICATIONS, Band IA-18, Nr. 4, Juli/August 1982, Seiten 411-415, IEEE, New York, US; D.Y. CHEN et al.: "Application of transistor emitter-open turn-off scheme to high voltage power inverters"
ELEKTRIE, Band 36, Nr. 7, 1982, Seiten 366-370, Ost-Berlin, DD; F. FISCHER et al.: "Leistungs-MOSFETs in der Energieelektronik Teil IV und Schluss"
ELECTRONIQUE APPLICATIONS, Nr. 31, August-September 1983, Seiten 35-44, Evry, FR; K. RISCH-MULLER: "Darlington, Bipmos, Cascode: caractéristiques et critères d'emploi"

(73) Patentinhaber : Siemens Aktiengesellschaft Berlin und München
Wittelsbacherplatz 2
D-8000 München 2 (DE)

(72) Erfinder : Hebenstreit, Ernst, Dipl.-Ing.
Am Blütenanger 14
D-8000 München (DE)

**Beschreibung**

Die Erfindung bezieht sich auf einen elektronischen Schalter mit einem MOSFET und einem Bipolartransistor, bei dem die Kollektor-Emitterstrecke des Bipolartransistors und die Drain-Sourcestrecke des MOSFET in Reihe geschaltet sind.

Ein solcher Schalter ist beispielsweise in der Zeitschrift « Elektronik », 23/1981, Seite 93 bis 96 beschrieben worden. Diese Schaltung trägt der Tatsache Rechnung, daß MOSFET für höhere Sperrspannungen, z. B. über 300 V, einen relativ hohen Durchlaßwiderstand $R_{on}$ aufweisen. Die Kombination aus bipolarem Transistor und MOSFET ermöglicht es, einen niedrigsperrenden MOSFET mit geringem Durchlaßwiderstand und einen hochsperrenden Bipolartransistor zu verwenden, dessen Durchlaßwiderstand niedriger als der eines entsprechend hochsperrenden MOSFET ist. Der Nachteil der beschriebenen Reihenschaltung besteht darin, daß für den Bipolartransistor eine gesonderte Gleichspannungsquelle notwendig ist oder aber ein dynamisch über einen Transformator aufgeladener Kondensator, dessen Kapazität auf die Taktfrequenz des Schalters abgestimmt sein muß, um ein Übersteuern des bipolaren Transistors zu verhindern.

Der Erfindung liegt die Aufgabe zugrunde, einen elektronischen Schalter der beschriebenen Gattung so weiterzubilden, daß seine Funktion von der Taktfrequenz unabhängig wird und eine gesonderte Spannungsquelle für den Bipolartransistor nicht erforderlich ist.

Diese Aufgabe wird gelöst durch die folgenden Merkmale :

a) Der Reihenschaltung aus bipolarem Transistor und MOSFET ist eine Reihenschaltung aus einen weiteren MOSFET und einem Schwellwertglied parallelgeschaltet,

b) das Schwellwertglied liegt zwischen dem Basisanschluß des bipolaren Transistors und demjenigen Anschluß des MOSFET, der nicht mit dem bipolaren Transistor verbunden ist,

c) den Gateanschlüssen der MOSFET wird ein Steuersignal zugeführt.

Die Erfindung wird an Hand zweier Ausführungsbeispiele in Verbindung mit den Fig. 1 bis 4 näher erläutert. Es zeigen :

Fig. 1 ein erstes Ausführungsbeispiel,

Fig. 2 ein zweites Ausführungsbeispiel,

Fig. 3 charakteristische Spannungs- und Stromverläufe der Anordnung nach Fig. 2 und

Fig. 4 ein drittes Ausführungsbeispiel.

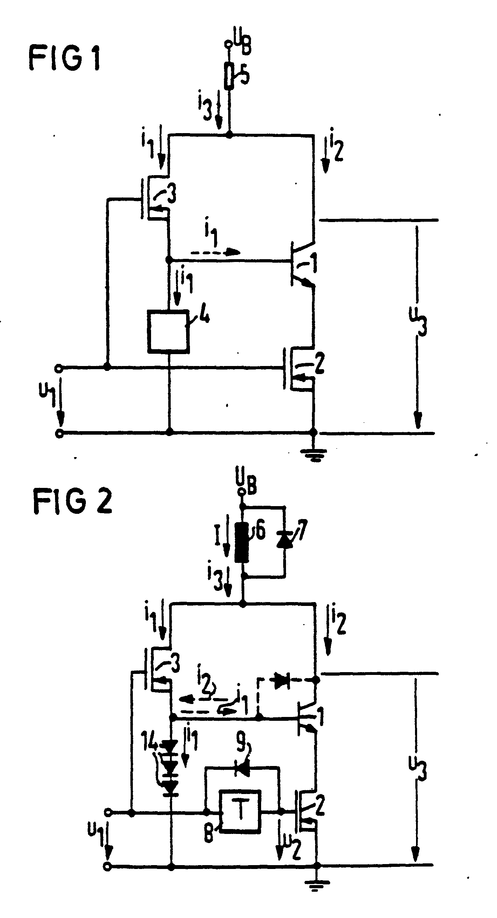

Der Schalter nach Fig. 1 weist eine Reihenschaltung aus einem hochsperrenden bipolaren Transistor 1 und einem relativ niedersperrenden MOSFET 2 auf. Sie liegt über eine Last 5 an einer Versorgungsspannung $U_B$. Der genannten Reihenschaltung aus Bipolartransistor und MOSFET ist eine Reihenschaltung aus einem weiteren MOSFET 3 und einem Schwellwertglied 4 parallelgeschaltet. Das Schwellwertglied, das aus einer Zenerdiode, einer Diode oder aus einer Reihenschaltung mehrerer Dioden bestehen kann, liegt zwischen dem Basisanschluß des Bipolartransistors 1 und demjenigen Anschluß des MOSFET 2, der nicht mit dem Bipolartransistor verbunden ist, in diesem Fall dem Sourceanschluß. Der weitere MOSFET 3 ist auf die Versorgungsspannung $U_B$ ausgelegt und ist daher hochsperrend. Die Gateanschlüsse der MOSFET 2, 3 sind mit einer Eingangsklemme verbunden, an die eine Steuerspannung $u_1$ anlegbar ist.

Zur Erläuterung der Funktion sei angenommen, daß keine Steuerspannung anliegt, der elektronische Schalter ist damit gesperrt. Am Ausgang der Reihenschaltung von Bipolartransistor 1 und MOSFET 2 liegt dann die Spannung $u_3$, die der Versorgungsspannung $U_B$ entspricht. Bei Anlegen einer Steuerspannung $u_1$ werden die MOSFET 2 und 3 leitend gesteuert. Diese Ansteuerung ist bis auf die dielektrischen Verluste in den MOSFET leistungslos. Durch den MOSFET 3 fließt dann ein Strom $i_1$, während der MOSFET 2 zunächst stromlos bleibt, da der Bipolartransistor 1 noch gesperrt ist. Jedoch geht das Emitterpotential des Transistors 1 gegen Null. Damit fließt der Strom $i_1$ zumindest teilweise als Basisstrom in den Bipolartransistor 1 und öffnet diesen. Ist die Schwellspannung des Schwellwertgliedes 4 höher als die Summe aus Basis-Emitterwiderstand des Bipolartransistors 1 und Drain-Sourcewiderstand des MOSFET 2, so hört der Stromfluß durch das Schwellwertglied 4 ganz auf. Der Laststrom fließt nun fast vollständig als Strom $i_2$ durch den Bipolartransistor 1 und den MOSFET 2. Durch den MOSFET 3 fließt nur der Steuerstrom $i_1$ für den Bipolartransistor 1. Da dieser Strom im allgemeinen gering ist, sind die Verluste im relativ hochohmigen MOSFET 3 vernachlässigbar gering. Der elektronische Schalter sperrt, wenn die Eingangsspannung $u_1$ Null wird.

Der Schalter nach Fig. 1 ist mit geringfügigen Abwandlungen auch für induktive Lasten mit Freilaufbetrieb anwendbar, wie er beispielsweise bei Motorstellern auftritt. Ein solcher Schalter ist in Fig. 2 dargestellt. Die Last besteht hier aus einer Induktivität 6 und einer Freilaufdiode 7. Eine solche Anordnung wird im Takt von z. B. einigen 10 kHz betrieben. Dabei wird ein mittlerer Laststrom I in den Taktpausen über die Freilaufdiode 7 geführt. Wird nun der elektronische Schalter eingeschaltet, so arbeitet er bis zum Freiwerden der Diode 7 im Kurzschluß und wird so der schärfsten Beanspruchung ausgesetzt.

Der Schalter selbst unterscheidet sich von dem nach Fig. 1 im wesentlichen dadurch, daß dem MOSFET 2 das Steuersignal $u_1$ über ein Verzögerungsglied 8 zugeführt wird. Dieses Verzögerungsglied ist für Spannungen derjenigen Polarität wirksam, die den MOSFET 2 in den leitenden Zustand steuern. Dies ist durch eine Diode 9 dargestellt, die das Verzögerungsglied 8 überbrückt. Beim Ausschalten des MOSFET 2 kann sich seine Gate-Sourcekapazität schnell entladen und der Transistor wird schnell gesperrt. Das Verzögerungsglied 8 kann z. B. aus einem Widerstand bestehen.

Beim Anlegen einer Steuerspannung $u_1$ wird wegen des Verzögerungsgliedes 8 zunächst nur der MOSFET 3 eingeschaltet. Der Strom fließt dann zunächst nur durch das Schwellwertglied 4, das wie oben aus einer Zenerdiode, einer Diode oder aus mehreren hintereinandergeschalteten Dioden 14 bestehen kann. Aufgrund des differentiellen Widerstandes der Dioden setzt eine Gegenkopplung für den MOSFET 3 ein, wodurch auftretende Stromspitzen im oben erwähnten Kurzschlußfall wirksam begrenzt werden. Nach der Verzögerungszeit T wird auch der MOSFET 2 eingeschaltet und senkt das Emitterpotential des bipolaren Transistors 1 ab. Damit geht der Strom $i_1$ als Steuerstrom auf den Transistor 1 über und schaltet diesen leitend. Damit fließt der Laststrom zum größten Teil als Strom $i_2$ durch die Transistoren 1 und 2.

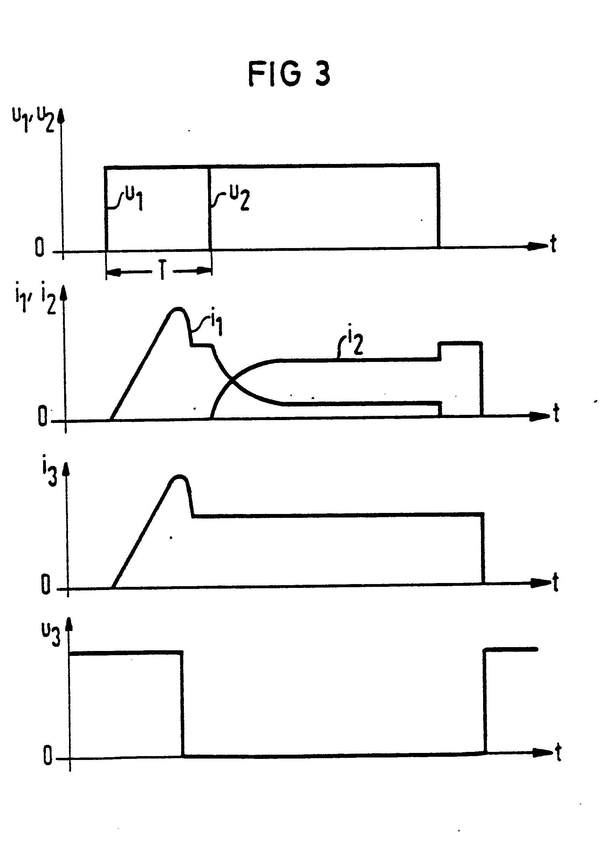

Um sicherzustellen, daß der Bipolartransistor 1 nicht überlastet wird, wird zweckmäßigerweise die Verzögerungszeit T größer als die Freiwerdezeit der Diode 7 gewählt. Damit beginnt ein nennenswerter Stromfluß durch den Transistor 1 erst dann, wenn die Spannung $u_3$ bereits abgefallen ist. Diese Verhältnisse sind in Fig. 3 dargestellt. Wird die Zenerspannung der als Schwellwertglied verwendeten Zenerdiode größer gemacht als die Summe aus Basis-Emitterspannung des Transistors 1 und Source-Drainspannung des MOSFET 2, so fließt der Strom $i_1$ völlig .als Steuerstrom zum Transistor 1. Im Fall der Verwendung einer oder mehrerer Dioden muß die Schwellspannung dieser Dioden größer als die Summe der erwähnten Spannungen sein.

Wird die Steuerspannung $u_1$ gleich Null werden die MOSFET 2 und 3 gleichzeitig gesperrt. Der Emitter des bipolaren Transistors 1 wird stromlos, wobei der Strom $i_2$ auf Grund der Speicherladung jetzt durch die Kollektor-Basisstrecke fließt. Damit wird der Beginn des Anstiegs der Ausgangsspannung $u_3$ verzögert. Der Anstieg selbst geht jedoch sehr schnell vor sich, da nur die Kapazität des Basis-Kollektor-pn-Überganges auszuräumen ist. Da bei einer Diode der Fall des sogenannten zweiten Durchbruchs, der auf einer thermischen Überlastung beruht, nicht auftreten kann, kann der Bipolartransistor 1 mit einer Sperrspannung beansprucht werden, die der höchstzulässigen Basis-Kollektor-Sperrspannung entspricht. Diese ist höher als die höchstzulässige Emitter-Kollektorspannung.

Die beschriebenen Schaltungen weisen den Vorteil auf, daß sie für die Ansteuerung des Bipolartransistors keine zusätzliche Spannungsquelle benötigen. Der Schalter ist ferner dann für Inversströme undurchlässig, wenn als Schwellwertglied eine oder mehrere Dioden verwendet werden. Damit können z. B. bei Brückenschaltungen ohne weiteres Freilaufdioden antiparallel geschaltet werden. Da die MOSFET keine Inversströme führen, entfallen die bekannten du/dt-Probleme beim Kommutieren.

In Verbindung mit Fig. 2 wurde ausgeführt, daß dem MOSFET 2 die Steuerspannung über ein Verzögerungsglied 8 zugeführt wird. Er kann jedoch auch durch eine gesonderte Taktquelle mit der entsprechenden zeitlichen Verschiebung angesteuert werden.

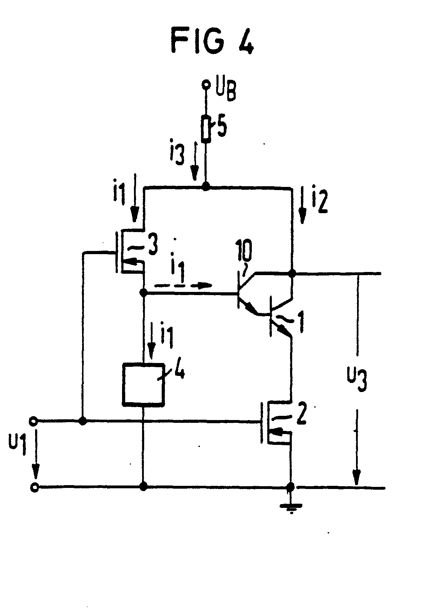

Die Schaltungen nach Fig. 1 und 2 können dadurch variiert werden, daß statt des dem MOSFET 2 in Reihe geschalteten einzelnen Bipolartransistors 1 dem MOSFET 2 ein Darlingtonverstärker aus zwei oder drei Bipolartransistoren in Reihe geschaltet wird. Eine solche Schaltung mit einem aus zwei Bipolartransistoren 1 und 10 bestehenden Darlingtonverstärker ist in Fig. 4 dargestellt. Hier ist die Emitter-Kollektorstrecke des zweiten (letzten) Bipolartransistors der Drain-Sourcestrecke des MOSFET 2 in Reihe geschaltet. Die Reihenschaltung aus dem weiteren MOSFET 3 und dem Schwellwertglied 4 ist der Reihenschaltung aus Bipolartransistor 1 und MOSFET 2 parallelgeschaltet. Das Schwellwertglied 4 liegt zwischen dem Basisanschluß des ersten Transistors 10 des Darlingtonverstärkers und dem Sourceanschluß des MOSFET 2.

In die Anordnung nach Fig. 4 kann auch wie bei der Anordnung nach Fig. 2 ein Verzögerungsglied 8 eingefügt werden, das bei einem Steuersignal derjenigen Polarität wirksam ist, das den MOSFET 2 leitend steuert.

**Patentansprüche**

1. Elektronischer Schalter mit einem MOSFET (2) und einem Bipolartransistor (1), bei dem die Kollektor-Emitterstrecke des Bipolartransistors und die Drain-Sourcestrekke des MOSFET in Reihe geschaltet sind, mit den Merkmalen:

a) Der Reihenschaltung aus Bipolartransistor (2) und MOSFET (1) ist eine Reihenschaltung aus einem weiteren MOSFET (3) und einem Schwellwertglied (4) parallelgeschaltet,

b) das Schwellwertglied (4) liegt zwischen dem Basisanschluß des bipolaren Transistors (1) und demjenigen Anschluß des MOSFET (2), der nicht mit dem bipolaren Transistor (1) verbunden ist,

c) den Gateanschlüssen der MOSFET (3, 2) wird ein Steuersignal ($u_1$) zugeführt.

2. Schalter nach Anspruch 1, dadurch gekennzeichnet, daß das Schwellwertglied (4) aus einer Diode oder aus mehreren in Reihe geschalteten Dioden (14) besteht.

3. Schalter nach Anspruch 1, dadurch gekennzeichnet, daß das Schwellwertglied (4) eine Zenerdiode ist.

4. Schalter nach einem der Ansprüche 1 bis 3, gekennzeichnet durch die Merkmale:

a) dem ersten MOSFET (2) wird das dem weiteren MOSFET (3) zugeführte Steuersignal über ein Verzögerungsglied (8) zugeführt,

b) das Verzögerungsglied (8) ist bei einem Steuersignal derjenigen Polarität wirksam, die den ersten MOSFET (2) leitend steuert.

5. Schalter nach Anspruch 4, dadurch gekennzeichnet, daß das Verzögerungsglied ein Widerstand mit parallelgeschalteter Diode (9) ist.

6. Schalter nach einem der Ansprüche 1 bis 3, dadurch gekennzeichnet, daß dem Gateanschluß des ersten MOSFET (2) ein Steuersignal aus einer gesonderten Taktquelle zugeführt wird.

7. Elektronischer Schalter mit einem MOSFET und mindestens einem Bipolartransistor, bei dem die Kollektor-Emitterstrecke des Bipolartransistors und die Drain-Sourcestrecke des MOSFET in Reihe geschaltet sind, gekennzeichnet durch die Merkmale :

a) Der Drain-Sourcestrecke des MOSFET ist die Kollektor-Emitterstrecke des letzten Bipolartransistors eines Darlingtonverstärkers in Reihe geschaltet,

b) der Reihenschaltung aus diesem Bipolartransistor und dem MOSFET ist eine Reihenschaltung aus einem weiteren MOSFET und einem Schwellwertglied parallelgeschaltet,

c) das Schwellwertglied liegt zwischen dem Basisanschluß des ersten Bipolartransistors des Darlingtonverstärkers und demjenigen Anschluß des MOSFET, der nicht mit dem letzten Bipolartransistor verbunden ist,

d) den Gateanschlüssen der MOSFET wird ein Steuersignal zugeführt.

8. Schalter nach Anspruch 7, gekennzeichnet durch die Merkmale :

a) dem ersten MOSFET (2) wird das dem weiteren MOSFET (3) zugeführte Steuersignal über ein Verzögerungsglied (8) zugeführt,

b) .das Verzögerungsglied (8) ist bei einem Steuersignal derjenigen Polarität wirksam, die den ersten MOSFET (2) leitend steuert.

## Claims

1. Electronic switch comprising a MOSFET (2) and a bipolar transistor (1), in which the collector-emitter path of the bipolar transistor and the drain-source path of the MOSFET are connected in series, characterized by :

a) the series circuit of bipolar transistor (2) and MOSFET (1) is connected in parallel with a series circuit of a further MOSFET (3) and a threshold element (4),

b) the threshold element (4) is connected between the base connection of the bipolar transistor (1) and the connection of the MOSFET (2) which is not connected to the bipolar transistor (1),

c) the gate connections of the MOSFET (3, 2) are supplied with a control signal (u₁).

2. Switch according to Claim 1, characterized in that the threshold element (4) consists of a diode or of several diodes (14) connected in series.

3. Switch according to Claim 1, characterized in that the threshold element (4) is a Zener diode.

4. Switch according to one of Claims 1 to 3, characterized by the features :

a) the first MOSFET (2) is supplied via a delay element (8) with the control signal supplied to the further MOSFET (3),

b) the delay element (8) is effective with a control signal of the polarity which controls the first MOSFET (2) to conduct.

5. Switch according to Claim 4, characterized in that the delay element is a resistor with diode (9) connected in parallel.

6. Switch according to one of Claims 1 to 3, characterized in that the gate connection of the first MOSFET (2) is supplied with a control signal from a separate clock source.

7. Electronic switch comprising a MOSFET and at least one bipolar transistor, in which the collector-emitter path of the bipolar transistor and the drain-source path of the MOSFET are connected in series, characterized by the features :

a) the drain-source path of the MOSFET is connected in series with the collector-emitter path of the last bipolar transistor of a Darlington amplifier,

b) the series circuit of this bipolar transistor and the MOSFET is connected in parallel with a series circuit of a further MOSFET and a threshold element,

c) the threshold element is connected between the base connection of the first bipolar transistor of the Darlington amplifier and the connection of the MOSFET which is not connected to the last bipolar transistor,

d) the gate connections of the MOSFETs are supplied with a control signal.

8. Switch according to Claim 7, characterized by the features :

a) the first MOSFET (2) is supplied via a delay element (8) with the control signal supplied to the further MOSFET (3),

b) the delay element (8) is effective with a control signal of the polarity which controls the first MOSFET (2) to conduct.

## Revendications

1. Commutateur électronique avec un MOSFET (2) et un transistor bipolaire (1), dans lequel le circuit connecteur-émetteur du transistor bipolaire et le circuit drain-source du MOSFET sont montés en série, présentant les caractéristiques suivantes :

a) en parallèle aux circuits série constitués par le transistor bipolaire (2) et par le MOSFET (1), est monté un circuit série constitué par un second MOSFET (3) et par une unité à valeur de seuil (4),

b) l'unité à valeur de seuil (4) est située entre la borne de base du transistor bipolaire (1) et la borne du MOSFET (2) qui n'est pas reliée au transistor bipolaire (1),

c) un signal de commande (u₁) est appliqué aux bornes de grille des MOSFET (3, 2).

2. Commutateur selon la revendication 1, caractérisé par le fait que l'unité à valeur de seuil (4) est constituée par une diode ou par plusieurs diodes (14) qui sont montées en série.

3. Commutateur selon la revendication 1, caractérisé par le fait que l'unité à valeur de seuil (4) est une diode Zener.

4. Commutateur selon l'une des revendications 1 à 3, caractérisé par les moyens suivants :

a) au premier MOSFET (2) on applique, par l'intermédiaire d'un élément à retard (8), le signal de commande qui est appliqué au second MOSFET (3),

b) l'élément à retard (8) est efficace pour un signal de commande dont la polarité commande le premier MOSFET (2) dans son état passant.

5. Commutateur selon la revendication 4, caractérisé par le fait que l'élément à retard est une résistance avec une diode (9) montée en parallèle.

6. Commutateur selon l'une des revendications 1 à 3, caractérisé par le fait qu'à la borne de grille du premier MOSFET (2) est appliqué un signal de commande provenant d'une source de cadence séparée.

7. Commutateur électronique comportant un MOSFET et au moins un transistor bipolaire, dans lequel le circuit collecteur-émetteur du transistor bipolaire et le circuit drain-source du MOSFET sont montés en série, caractérisé par les moyens particuliers suivants :

a) en série avec le circuit drain-source du MOSFET, est relié le circuit collecteur-émetteur du dernier transistor bipolaire d'un amplificateur de Darlington,

b) en parallèle sur le circuit série constitué par ledit transistor bipolaire et le MOSFET, est monté un circuit série constitué par un second MOSFET et par une unité à valeur de seuil,

c) l'unité à valeur de seuil se situe entre la borne de base du premier transistor bipolaire de l'amplificateur de Darlington et la borne du MOSFET qui n'est pas reliée au dernier transistor bipolaire,

d) un signal de commande est appliqué aux bornes de grille des MOSFETS.

8. Commutateur selon la revendication 7, caractérisé par les points remarquables suivants :

a) au premier MOSFET (2) on applique, par l'intermédiaire d'un élément à retard (8), le signal de commande qui est appliqué au second MOSFET (3),

b) l'élément à retard (8) est rendu efficace pour un signal de commande qui a la polarité qui commande le premier MOSFET (2) dans son état passant.

FIG 1

FIG 2

# FIG 3

# FIG 4